(19)

**Europäisches Patentamt**
**European Patent Office**
**Office européen des brevets**

(11)　**EP 3 259 862 B1**

(12)　　　　　**EUROPEAN PATENT SPECIFICATION**

(45) Date of publication and mention
of the grant of the patent:
**27.05.2020　Bulletin 2020/22**

(21) Application number: **15706010.4**

(22) Date of filing: **20.02.2015**

(51) Int Cl.:
*H04L 1/00* (2006.01)　　　　*H04L 1/20* (2006.01)

(86) International application number:
**PCT/EP2015/053641**

(87) International publication number:
**WO 2016/131497 (25.08.2016 Gazette 2016/34)**

(54) **CONTROL OF RADIO CONNECTIONS IN A CELLULAR NETWORK**

STEUERUNG VON FUNKVERBINDUNGEN IN EINEM MOBILFUNKNETZ

COMMANDE DE CONNEXIONS RADIO DANS UN RÉSEAU CELLULAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**27.12.2017　Bulletin 2017/52**

(73) Proprietor: **Telefonaktiebolaget LM Ericsson
(publ)
164 83 Stockholm (SE)**

(72) Inventors:
• **MENDO MATEO, Adriano
E-29590 Malaga (ES)**

• **DURAN MARTINEZ, Alvaro
E-29071 Malaga (ES)**
• **RUIZ VEGA, Fernando
E-29071 Malaga (ES)**
• **TORIL GENOVÉS, Matías
E-29071 Malaga (ES)**

(74) Representative: **Zacco Sweden AB
P.O. Box 5581
114 85 Stockholm (SE)**

(56) References cited:
**WO-A1-2010/041990　　US-A1- 2015 036 602
US-A1- 2015 049 703**

**Description**

Technical Field

The present invention relates to methods for controlling radio connections in a cellular network and to corresponding devices.

Background

In cellular networks, such as cellular networks as specified by 3GPP (3rd Generation Partnership Project), it is known to perform link adaptation depending on radio channel quality between a user equipment (UE) and the cellular network. As for example specified in 3GPP TS 36.300 V12.4.0 (2014-12) for the LTE radio technology, a link adaptation process referred to as Adaptive Modulation and Coding (AMC) may be applied to select modulation schemes and coding rates per Transmission Time Interval (TTI).

As for example described in "CQI Reporting Imperfections and their Consequences in LTE Networks", Aho, K.; Alanen O. & Kaikkonen J., in 10th International Conference on Networks (ICN), January 2011, pp. 241-245, ISSN 2308-4413, ISBN 978-1-61208-113-7, the AMC process may be based on two mechanisms, referred to as Inner Loop Link Adaptation (ILLA) and Outer Loop Link Adaptation (OLLA). On the basis of a Channel Quality Indicator (CQI) reported by the UE, the ILLA mechanism decides on the Modulation and Coding Scheme (MCS) to be used in the next TTI. The OLLA mechanism aims at compensating for any bias in the reported CQI, which may for example be introduced by measurement inaccuracies, age of CQI reports, or new receiver architectures, so that for each radio connection a base station (BS) in the long term selects the MCS that best suits the radio channel conditions. The OLLA mechanism may operate on the basis of Hybrid Automatic Repeat Request (HARQ) from the UE.

More specifically, the OLLA mechanism may correct a Signal-to-Interference-plus-Noise (SINR) value obtained from the reported CQI by subtracting an offset. Starting from an initial value, this offset may in turn be adapted depending on the received HARQ feedback, in order to meet a target Block Error Rate (BLER).

Several suggestions have been made with respect to improving OLLA mechanisms, specifically with the aim of quickly matching actual channel conditions and thus maximizing data throughput.

For example, in "Improving HSDPA link adaptation by considering the age of CQI", Muller, A.; Chen, T., in 62nd IEEE Vehicular Technology Conference (VTC), September 2005, vol. 3, pp. 1643-1647, ISSN 1090-3038, an enhanced OLLA mechanism for HSDPA (High Speed Downlink Packet Access) is proposed. This enhanced OLLA mechanism takes into account the age of the CQI feedback.

US 2015/0049703 A1 describes that an initial OLLA offset may be set based on a statistical value. WO 2010/041990 A1 describes generating an initial CQI value based on channel measurements and using historic initial CQI values.

However, irrespective of such improvements concerning the evaluation of CQI reports, existing link adaptation mechanisms may be sensitive to selection of parameters of the OLLA mechanism, such as step sizes of adapting the applied offset, which may result in a trend to utilizing excessively conservative parameter values and in a sacrifice of performance.

Accordingly, there is a need for techniques which allow for efficiently adapting radio connections in a cellular network.

Summary

The invention is defined and limited by the scope of appended claims. In the following description, any embodiments referred to and not falling within the scope of the appended claims, are merely examples useful to the understanding of the invention.

Details of such embodiments and further embodiments will be apparent from the following detailed description of embodiments.

Brief Description of the Drawings

Fig. 1 schematically illustrates a cellular network architecture in which link adaptation according to an embodiment of the invention may be performed.

Fig. 2 schematically illustrates a link adaptation system according to an embodiment of the invention.

Fig. 3 shows a flowchart for illustrating a link adaptation process to an embodiment of the invention.

Fig. 4 schematically illustrates definition of histogram bins of an OLLA offset histogram as utilized in an embodiment of the invention.

Fig. 5 schematically illustrates definition of histogram bins of an OLLA offset histogram as utilized in an exemplary link adaptation scenario.

Fig. 6 schematically illustrates an OLLA offset histogram as obtained in the exemplary link adaptation scenario.

Fig. 7 schematically illustrates an OLLA offset histogram as obtained in the exemplary link adaptation scenario when considering only low activity radio connections.

Fig. 8 schematically illustrates an OLLA offset histogram as obtained in the exemplary link adaptation scenario when considering only high activity radio connections.

Fig. 9 shows a flowchart for schematically illustrating a method according to an embodiment of the invention.

Fig. 10 schematically illustrates a cellular network node according to an embodiment of the invention.

Detailed Description of Embodiments

In the following, concepts in accordance with exemplary embodiments of the invention will be explained in more detail and with reference to the accompanying drawings. The illustrated embodiments relate to control of radio connections between a cellular network and communication devices, in the following also referred to as UEs. In the illustrated examples, it is assumed that the cellular network is based on a radio technology in which a base station providing a certain radio connection is also responsible for implementing a link adaptation mechanism for the radio connection. Examples of such radio technologies are the LTE radio technology or the UMTS (Universal Mobile Telecommunications System) radio technology enhanced by HSPA (High Speed Packet Access). However, it is to be understood that the illustrated concepts could also be applied to other radio technologies, e.g., non-3GPP cellular network technologies or UMTS without HSPA.

In the illustrated concepts, it is assumed that a link adaptation mechanism operates on the basis of an ILLA process and an OLLA process for each radio connection between the cellular network and the UEs. Such radio connection may for example correspond to a Radio Resource Control (RRC) session established between the cellular network and the UE. A radio link between a certain UE and the cellular network may be based on multiple radio connections, which may be established simultaneously or sequentially. The ILLA process is responsible for selecting an MCS for the radio connection depending on a signal quality value. The OLLA process is responsible for adapting the signal quality value applied in the ILLA process by an offset and adapting the offset depending on feedback related to transmissions on the radio connection. This offset, as adapted by the OLLA process, is monitored. This monitoring may for example involve generating histograms of the applied offset values for multiple radio connections. On the basis of the monitored offset values, an optimized initial value of the offset is determined. This initial value may then be applied when establishing one or more new radio connection to a UE. By setting the initial value on the basis of the monitored offset values, convergence of the OLLA process towards an optimized value, e.g., for which a certain target BLER is met, can be expedited. The monitoring of the offset values and determination of the optimized initial value may be performed by a centralized node of the cellular network, such as by an Operation Support System (OSS). Such centralized node may receive reports of the applied offset values from access nodes of the cellular network, e.g., base stations of the cellular network, and may then indicate the determined initial value to the base stations. Alternatively or in addition, the monitoring of the offset values and determination of the initial value could also be implemented locally at each access node.

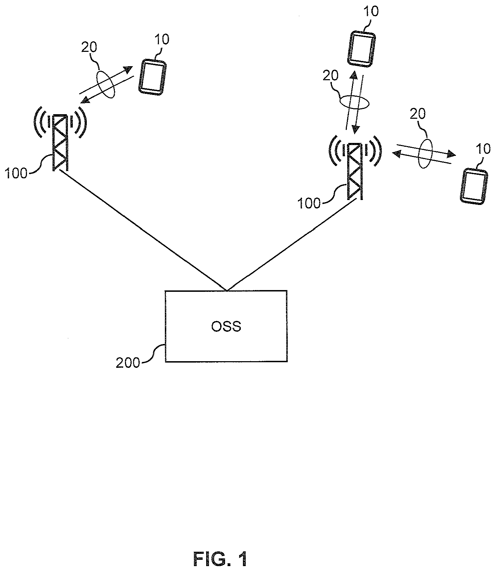

Fig. 1 schematically illustrates a cellular network architecture which may be used for implementing the concepts as outlined above. In particular, Fig. 1 illustrates UEs 10 and radio links 20 of the UEs 10 to the cellular network. As illustrated, the radio links 20 are formed between each UE 10 and a corresponding base station 100 of the cellular network. Each radio link 20 may in turn include a DL part for transmissions from the cellular network to the UE 10 and an uplink (UL) part for transmissions from the UE 10 to the cellular network. Further, Fig. 1 illustrates an OSS 200 of the cellular network. The OSS 200 is responsible for monitoring and managing the base stations 100. In the illustrated concepts, the OSS 200 may be responsible for monitoring the offset values applied by the OLLA processes of radio connections on the radio links 20, and for determining the initial offset value, from which the adaptation of the offset value in OLLA processes starts.

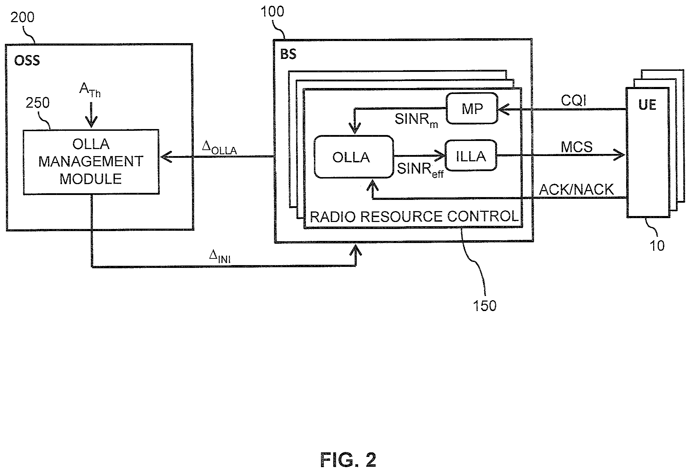

Fig. 2 shows a block diagram for further illustrating a link adaptation system as applied for optimizing the initial value of the offset. As illustrated, a base station (BS) 100, e.g., one of the base stations 100 of Fig. 1, implements a radio resource control process 150 for each radio connection to a UE 10. The radio resource control process 150 involves a measurement process (MP) which determines a signal quality value $SINR_m$ for the radio connection, e.g, in terms of a Signal-to-Interference-plus-Noise-Ratio (SINR), an OLLA process which adapts the determined signal quality value by applying an offset $\Delta_{OLLA}$, and an ILLA process, which selects an MCS depending on the adapted signal quality value $SINR_{eff}$. For the DL part, the measurement process may determine the signal quality value $SINR_m$ from reports provided by the UE 10. As illustrated, the UE 10 may for example report a CQI, and the measurement process may determine the signal quality value from the reported CQI. For the UL part, the measurement process may determine the signal quality value $SINR_m$ from measurements performed by the base station, e.g., measurements on reference signals transmitted by the UE 10.

The OLLA process may determine the adapted signal quality value $SINR_{eff}$ according to:

$$SINR_{eff} = SINR_m - \Delta_{OLLA} \, . \tag{1}$$

Further, the OLLA process adapts the offset $\Delta_{OLLA}$ depending on feedback concerning transmissions between the UE 10 and the cellular network, starting from the initial value of the offset, in the following denoted as $\Delta_{INI}$. As illustrated, such feedback may be based on positive HARQ acknowledgements (ACKs) and negative HARQ acknowledgements (NACKs). For the DL part such HARQ ACKs and HARQ NACKs would be sent by the UE 10, and for the UL part such HARQ ACKs and HARQ NACKs would be sent by the base station 100. The adaptation of the offset $\Delta_{OLLA}$ may for example aim at meeting a certain target BLER. The adaptation of the offset $\Delta_{OLLA}$ may be implemented by either increasing the offset $\Delta_{OLLA}$ by a positive step $\Delta_{UP}$ or decreasing the offset $\Delta_{OLLA}$ by a negative step $\Delta_{DOWN}$, depending on whether a HARQ ACK or HARQ NACK is received.

The target BLER, $BLER_T$, may for example be set to values between 1% and 10%, depending on the network and HARQ configuration. For a given value of $BLER_T$, the parameters $\Delta_{UP}$ and $\Delta_{DOWN}$ may then be selected to meet the relation

$$BLER_T = \frac{1}{1 + \dfrac{\Delta_{UP}}{\Delta_{DOWN}}} \, . \tag{2}$$

In the case of a HARQ NACK, the offset $\Delta_{OLLA}$ may be increased according to:

$$\Delta_{OLLA} = \Delta_{OLLA} + \Delta_{UP} \, . \tag{3}$$

In the case of a HARQ ACK, the offset $\Delta_{OLLA}$ may be decreased according to:

$$\Delta_{OLLA} = \Delta_{OLLA} - \Delta_{DOWN} \approx \Delta_{OLLA} - \Delta_{UP} \cdot BLER_T \, . \tag{4}$$

The selected MCS thus also depends on the transmitted HARQ ACKs or NACKs and the parameters $\Delta_{UP}$ and $\Delta_{DOWN}$, and on the initial value of the offset $\Delta_{INI}$ from which the adaptation of the OLLA process starts. The initial value of the offset $\Delta_{INI}$ determines the initial state of the OLLA process, while the parameters $\Delta_{UP}$ and $\Delta_{DOWN}$ (and the number of received HARQ ACKs and HARQ NACKs) determine how quickly the OLLA process converges. As a general rule, higher values of the parameters $\Delta_{UP}$ and $\Delta_{DOWN}$ may expedite convergence, but may also increase the risk of instabilities. Further, convergence may also be expedited by selecting the initial value of the offset $\Delta_{INI}$ close to an optimum value of the offset $\Delta_{OLLA}$ towards which the OLLA process converges. In the illustrated concepts, such optimized selection of the initial value of the offset $\Delta_{INI}$ may be achieved by monitoring the applied offset $\Delta_{OLLA}$ and determining the initial value of the offset $\Delta_{INI}$ on the basis of this monitoring.

As illustrated in Fig. 2, this may be implemented by providing the OSS 200 with an OLLA management module 250, which receives reports of the offset $\Delta_{OLLA}$ as applied for different radio connections from the base station 100, and typically also from other base stations, and determines the initial value of the offset $\Delta_{INI}$ depending on the monitored values of the offset $\Delta_{OLLA}$. The determined initial value of the offset $\Delta_{INI}$ may then be loaded to the base station 100 to be applied in newly started OLLA processes.

The monitoring of the applied values of the offset $\Delta_{OLLA}$ may be based on histograms. Such histograms, or data for generating such histograms, may be provided by each base station on a per radio connection basis. Each histogram may be defined as of an array of N elements, $A_{OLLA}[1..N]$, of which each reflects the number of occurrences of a value of the offset $\Delta_{OLLA}$ in a given one of N different intervals, also referred to as bins. Further, the monitoring may involve selecting those values of the offset $\Delta_{OLLA}$ which are associated with radio connections having an activity level which exceeds a certain threshold value $A_{Th}$. The activity level may be measured in terms of a number of HARQ ACKs and HARQ NACKs for the considered radio connection, and the threshold value $A_{Th}$ define a minimum number of HARQ ACKs and NACKs above which the radio connection is considered as a high activity radio connection. The threshold $A_{Th}$ may be input as a predefined value to the OLLA management module 250 or may be pre-selected by the OLLA management module 250.

Accordingly, by comparing the number of HARQ ACKs and HARQ NACKs for the radio connection to the threshold value $A_{Th}$, the monitored radio connections may be classified into low activity radio connections and high activity radio connections. As further explained below, it may be beneficial to utilize only the values of the offset $\Delta_{OLLA}$ as monitored for high activity radio connections as a basis for determining the initial value of the offset $A_{OLLA}$. The determined initial value of the offset $\Delta_{INI}$ may be applied to all UEs connected to the cell served by the base station 100, or to all UEs connected to cells served by the base stations for which the offset $\Delta_{OLLA}$ is monitored.

By utilizing the monitoring results of only high activity radio connections as a basis for determining the initial value of the offset $\Delta_{INI}$, it can be taken into account that such radio connections will typically reach a steady state of the OLLA process because there is a sufficient number of iterative adaptations of the offset $\Delta_{OLLA}$, which means that the adapted value of the offset $\Delta_{OLLA}$ would have reached a value close to its optimum value, while for low activity radio connections the adapted value of the offset $\Delta_{OLLA}$ at the end of the radio connection may still deviate from the optimum value. If the initial value of the offset $\Delta_{INI}$ is chosen close to the optimum value, less iterations of the OLLA process are needed to reach the optimum value. Thus, the final value of the offset $\Delta_{OLLA}$ observed for high-activity radio connections constitutes a reasonable setting for the initial value of the offset $\Delta_{INI}$. Here, it should be noted that particularly low activity radio connections may benefit from such optimized setting of the initial value of the offset $\Delta_{INI}$, because it allows for reaching a value of the offset $\Delta_{OLLA}$ which is close to the optimum value even if the low activity level results in sparse HARQ feedback and a small number of iterations of the OLLA process during the radio connection. Accordingly, the determined initial value of the offset $\Delta_{INI}$ may be applied to both high activity radio connections and low activity radio connections, allowing low activity radio connections to benefit from the information gathered by monitoring high activity radio connections.

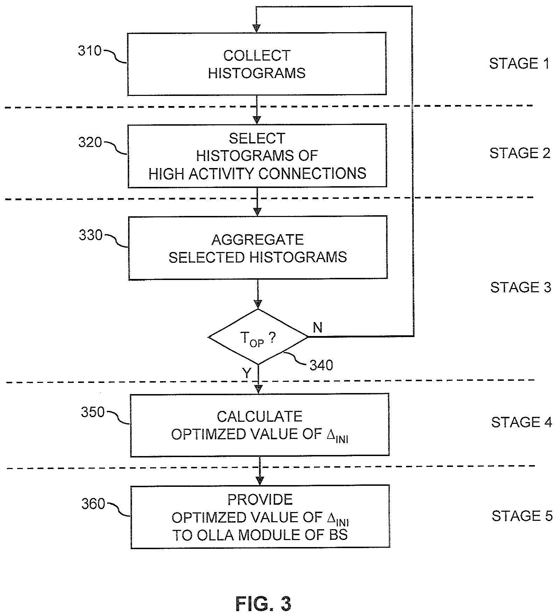

Fig. 3 illustrates an exemplary implementation of the link adaptation process as outlined above. In the example of Fig. 3, it is assumed that during a measurement period ($T_{MP}$) a histogram of the applied value of the offset $\Delta_{OLLA}$ is generated for each radio connection. The histograms for high activity radio connections collected over an optimization period $T_{OP}$ are aggregated to a single histogram which is utilized as a basis for determining the initial value of the offset $\Delta_{INI}$. The measurement period $T_{MP}$ can be equal or less than the optimization period $T_{OP}$, which allows for flexibly determining when to update the initial offset value $\Delta_{INI}$ at the base station 100. The initial value of the offset $\Delta_{INI}$ may be determined individually for each cell or may be determined for a group of cells having similar characteristics, e.g., served by similar base station equipment. The determined initial value of the offset $\Delta_{INI}$ is then applied in the OLLA processes of the next optimization period $T_{OP}$, in which new histograms of the applied value of the offset $\Delta_{OLLA}$ may be collected to be used as a basis for iteratively re-determining the initial value of the offset $\Delta_{INI}$. As illustrated in Fig. 3, the link adaptation process may be organized in five stages.

In a first stage, as illustrated by step 310, the histograms of the applied value of the offset $\Delta_{OLLA}$ are collected. This may be accomplished on the basis of counters implemented by the base station 100. In particular, a histogram of the applied value of the offset $\Delta_{OLLA}$ may be generated for each radio connection established by the base station during the measurement period $T_{MP}$. The histograms may then be reported to the OSS 200.

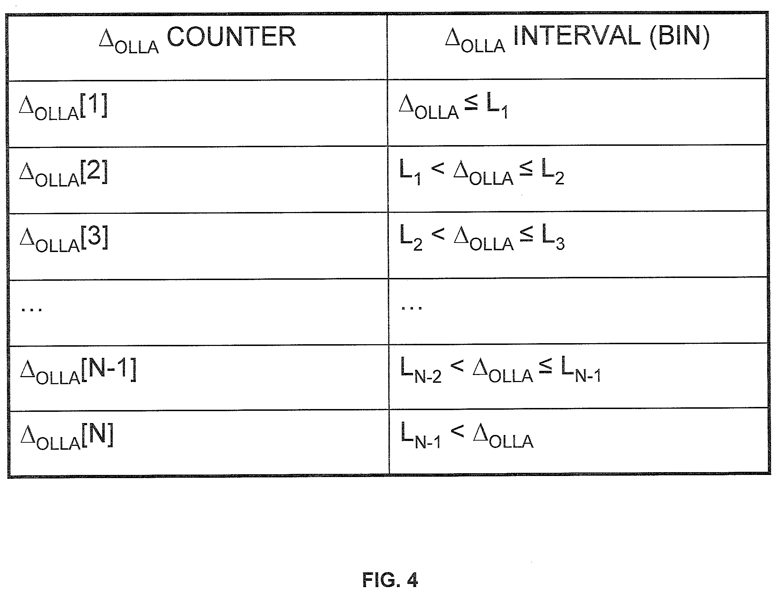

The collected histograms may for example be defined as illustrated in Fig. 4. In the example of Fig. 4, each bin of the histogram counts the number of TTIs in which the applied value of the offset $\Delta_{OLLA}$ was within a corresponding interval. As illustrated, the histogram comprises N bins, each associated with a corresponding interval of the value of the offset $A_{OLLA}$. The upper limit of the interval corresponding to the i-th bin is denoted by $L_i$.

In a second stage, as illustrated by step 320, the histograms of high activity radio connections are selected from the collected histograms, e.g., by applying a filter which selects those histograms associated with a radio connection having an activity level above the threshold $A_{Th}$. Here, the activity level of a radio connection may be measured in terms of the total number of HARQ ACKs and HARQ NACKs experienced in the course of the radio connection, e.g., between RRC connection establishment and RRC connection termination. Radio connections having an activity level exceeding the threshold $A_{Th}$ may be classified as high activity radio connections.

In a third stage, as illustrated by steps 330 and 340, the selected histograms are aggregated to a single histogram. This is accomplished over the optimization period by re-iterating steps 310 to 330 until the end of the optimization period $T_{OP}$ is reached.

In the third stage, a single aggregated histogram $\Delta_{OLLA}(A_n)[1..N]$ for the n-th measurement period $T_{MP}$ may be

calculated according to:

$$\Delta_{OLLA}\left(A_n\right)[j] = \sum_{i=1}^{k} \Delta_{OLLA}(i)[j] \qquad (5)$$

with j=1,...,N. Here, j denotes the index of each bin comprising the histogram (j=1...N) and i denotes a specific radio connection out of a total of k radio connections within the n-th measurement period $T_{MP}$, $\Delta_{OLLA}(i)[j]$ represents the j-th bin of the histogram of the i-th radio connection and $A_{OLLA}(A_n)[j]$ represents the total connection time (in TTIs) where a value of the offset $\Delta_{OLLA}$ within the interval corresponding to the j-th bin was applied for one high-activity radio connection in the considered cell.

Aggregation of a number M of measurement periods $T_{MP}$ over the optimization period $T_{OP}$ may be performed according to:

$$\Delta_{OLLA}\left(A\right)[j] = \sum_{n=1}^{M} \Delta_{OLLA}\left(A_n\right)[j]. \qquad (6)$$

In a fourth stage, when the end of the optimization period $T_{OP}$ is reached, the resulting aggregated histogram is analyzed to calculate the initial value of the offset $\Delta_{INI}$, as illustrated by step 350.

The aim of the fourth stage is to estimate the most likely value of the offset $\Delta_{OLLA}$ at the end of a typical radio connection of infinite duration from the aggregated histogram of the third stage. Here, a radio connection which is representative of radio conditions in the cell and during the considered optimization period $T_{OP}$ may be considered as a typical radio connection.

For high activity radio connections, the bin of the aggregated histogram having the highest value typically corresponds to the final value of the offset $\Delta_{OLLA}$, because it can be expected that a steady state of the OLLA process was reached well before the end of the radio connection. Accordingly, an offset value corresponding to this bin, e.g., equal to the center value of the interval defining the bin, may be selected as the initial value of the offset $\Delta_{INI}$.

In addition or as an alternative, also other ways of analyzing the aggregated histogram may be applied. For example, the initial value of the offset $\Delta_{INI}$ may be calculated as a mean value of the aggregated histogram according to:

$$\Delta_{INI} = \overline{\Delta}_{OLLA} = \frac{1}{n_\Delta} \sum_{j=1}^{N} LC_j \cdot \Delta_{OLLA}(A)[j], \qquad (7)$$

with

$$n_\Delta = \sum_{j=1}^{N} \Delta_{OLLA}(A)[j] \qquad (8)$$

denoting the total number of samples collected in the aggregated histogram, and

$$LC_j = \begin{cases} \dfrac{L_{j-1} + L_j}{2} & , \quad 0 < j < N \\[4mm] L_j & , \quad j = 0 \text{ or } j = N \end{cases} \qquad (9)$$

denoting the center value of the interval corresponding to the j-th bin of the histogram.

Further, also a median value of the histogram, a mode value of the histogram, or a certain percentile value of the histogram may be utilized as a basis for determining the initial value of the offset $\Delta_{INI}$. If the median value is utilized linear interpolation can be applied within the interval corresponding to the bin containing the median value in order to improve resolution of the determined median value. Here, it should be noted that the median value may be regarded as a specific example of a percentile value where the percentile index is 50%. In the case of utilizing a percentile value, other percentile indices could be used, for example 70% or 80%. In the same way as for the median value, linear interpolation will improve the resolution for the percentile value.

In a fifth stage, as illustrated by step 360, the calculated initial value of the offset $\Delta_{INI}$ is provided to the base station 100 to be applied in the OLLA processes of the next optimization period $T_{OP}$.

In the above examples, it was assumed that the histograms of the applied values of the offset $\Delta_{OLLA}$ are collected on a per radio connection basis, e.g., similar to UE performance monitoring recording traces. In this case, time stamps indicating start and end of each radio connection are available and may be utilized in the process of identifying the high activity radio connections. As an alternative, the histograms of the applied values of the offset $\Delta_{OLLA}$ may also be collected on a per cell basis, without distinguishing between individual radio connections. In this case, the filtering of histograms associated with high activity connections may be omitted.

Further, rather than implementing the determination of the initial value of the offset $\Delta_{INI}$ in a centralized manner, e.g., in the OSS 200, this determination could also be performed locally within each base station 100.

Further, the determination of the initial value of the offset $\Delta_{INI}$ may be performed on a periodic basis, e.g., by iteratively repeating the link adaptation process of Fig. 3, or may be manually triggered. In the latter case, it may be sufficient to determine the initial value of the offset $\Delta_{INI}$ on the basis of only one optimization period $T_{OP}$.

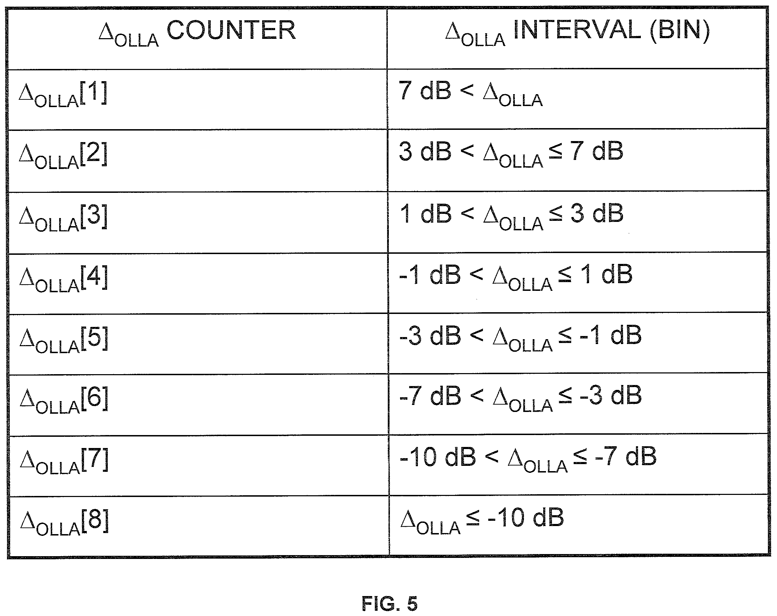

In the following, application of the illustrated link adaptation process will be discussed with reference to an exemplary scenario based on data measured in an LTE cellular network. The considered data include applied values of the offset $\Delta_{OLLA}$, aggregated histograms of the applied values of the offset $\Delta_{OLLA}$, and time stamps indicating the start and end of connections in a cluster of 769 LTE cells, distributed over two carriers. All parameters and measurements relate to the DL transmission direction. The considered time period covers 12 hours (from 8:00 to 20:00) during which 2700266 radio connections were registered. For each radio connection, several indicators are available, namely throughput on the PDCP (Packet Data Convergence Protocol) layer and radio layer, scheduling time, number of HARQ ACKs and HARQ NACKs, and histograms of the applied values of the offset $A_{OLLA}$. Fig. 5 shows the configuration of the collected histograms. The initial value of the offset $\Delta_{INI}$ was set to a starting value of 0 dB, corresponding to bin $\Delta_{OLLA}[4]$ of the histogram. The threshold $A_{Th}$ was set to 1000, i.e., histograms associated with radio connections for which more than 1000 HARQ ACK and HARQ NACKs classified as high activity radio connections, while the other radio connections were classified as low activity radio connections.

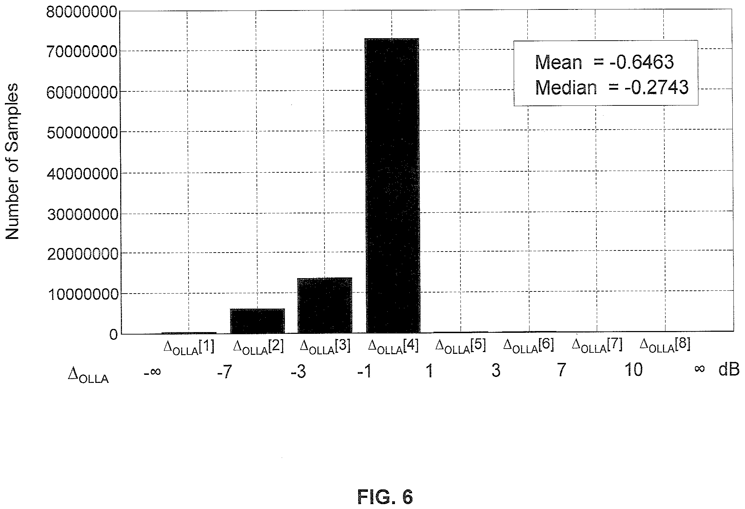

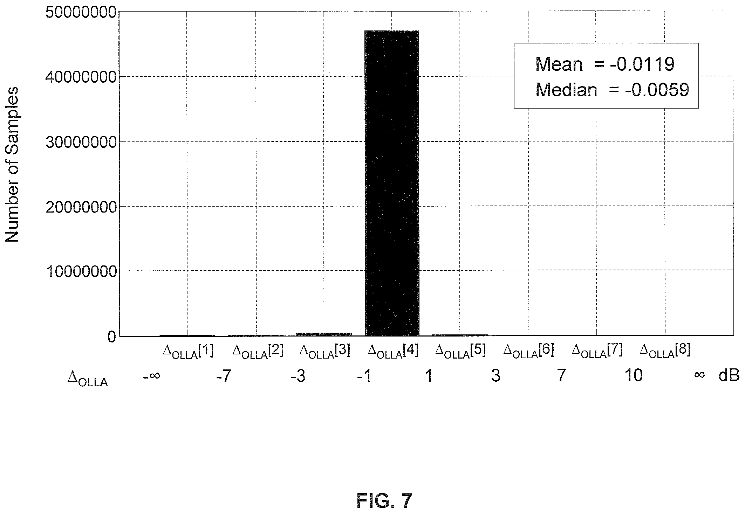

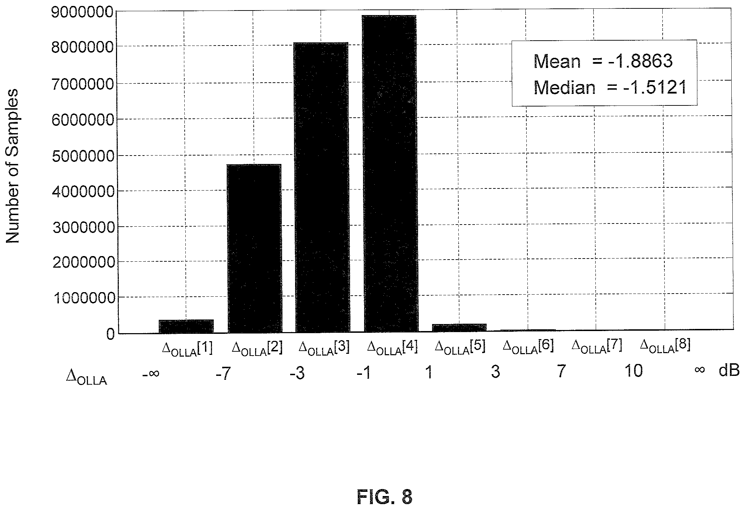

Fig. 6 shows the observed aggregated histogram for all radio connections, cells and measurement periods $T_{MP}$. It can be seen that $\Delta_{OLLA}[4]$ is the prevailing bin. The mean and median values of the histogram are -0.65 dB and -0.27 dB, respectively. Fig. 7 shows the observed aggregated histogram when considering only low-activity radio connections, which in the illustrated scenario correspond to about 95% of all radio connections. Here, it can be seen that actually only one bin of the histogram includes almost all samples. This is due to the low activity level of the considered radio connections, resulting in only few adaptations of the initial value of the offset $\Delta_{INI}$, without any significant deviation therefrom. The mean and median values of the histogram are -0.012 dB and -0.006 dB, respectively. Fig. 8 shows the observed aggregated histogram for when considering only high activity radio connections, for which the amount of observed HARQ ACKs and HARQ NACKs are above the threshold of $A_{Th}=1000$. These radio connections represent only 0.18% of the total number of monitored radio connections. It can be seen that, as compared to Fig. 6, a significant portion of the samples are outside bin $\Delta_{OLLA}[4]$, although $\Delta_{OLLA}[4]$ is still the prevailing bin. The increase in the number of samples in the bins $\Delta_{OLLA}[1]$, $\Delta_{OLLA}[2]$ and $\Delta_{OLLA}[3]$ is due to the fact that activity during the radio connections is long enough to cause a significant deviation of the applied offset $\Delta_{OLLA}$ from its initial value $\Delta_{INI}$. For the histogram of Fig. 8, the mean and median values are -1.89 dB and -1.51 dB, respectively, which is much lower than the initial value of the offset of $\Delta_{INI}=0$ dB. Further analysis shows that also for larger values of $A_{Th}$ the shape of the histogram is almost the same.

As explained above, the optimized value of the initial value of the offset $\Delta_{INI}$ may be calculated as the median value of the histogram for the high activity radio connections, i.e., as $\Delta_{INI}=-1.51$ dB, or alternatively as the mean value of the histogram for the high activity radio connections, i.e., as $\Delta_{INI}=-1.89$ dB. After setting the initial value of the offset $\Delta_{INI}$ accordingly, it can be expected that the all histograms, both for low activity radio connections and high activity radio connections, are concentrated on the optimum bin, in this case $\Delta_{OLLA}[3]$.

The above discussion of the histograms in Figs. 6 to 8 shows that monitoring the applied value of the offset $\Delta_{OLLA}$ allows for optimizing the initial value of the offset $\Delta_{INI}$ used as the starting point of each OLLA process. A more comprehensive analysis carried out by executing the above-described link adaptation process with re-determination of the initial value of the offset $\Delta_{INI}$ on a per-cell and hourly basis shows that the optimized value of $\Delta_{INI}$ may vary depending on the time, but depending on the specific cell. Accordingly, it may be possible to apply the determined optimized initial value of the offset $\Delta_{INI}$ to multiple cells. Further, it may be beneficial to re-determine optimized initial value of the offset $\Delta_{INI}$ repeatedly over a certain time period, e.g., a day, to take into account the time dependent variations.

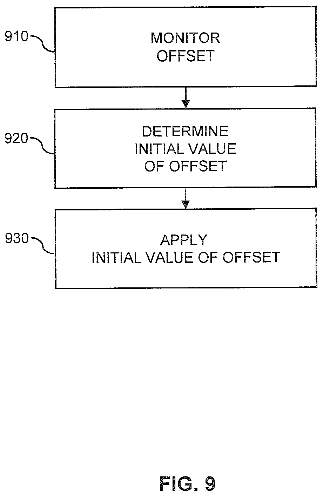

Fig. 9 shows a flowchart for illustrating a method which may be utilized for implementing the illustrated concepts. The method may be applied for controlling radio connections in a cellular network. The method may be performed by a node of the cellular network, e.g., by an access node which is responsible for performing link adaptation for radio connections to communication devices, such as a base station, e.g. the base station 100, or by a more centralized node, such as an OSS node, e.g. the OSS 200. If a processor-based implementation of the node is used, the steps of the method may be performed by one or more processors of the node. The communication devices to which the radio connections are established may correspond to UEs. However, the radio connections could also be established to other kinds of communication devices, such as relay nodes or devices having only modem functionality.

At step 910, the node monitors an offset which is applied by at least one access node of the cellular network to adapt a signal quality value determined for a radio connection to a communication device, such as the above-mentioned offset $A_{OLLA}$. The signal quality value may be determined as an SINR. However, other representation of the signal quality value could be utilized as well, e.g., a CQI.

The adapted signal quality value is applied by the access node in a first control loop to select a modulation and coding scheme for the radio connection. The first control loop may be based on an ILLA process. The offset is adapted by the access node in a second control loop, starting from an initial value and depending on feedback information for transmissions on the radio connection. The feedback information may include positive or negative acknowledgements of a HARQ protocol. For the DL transmission direction, such acknowledgements may be transmitted from the communication device to the cellular network. For the UL transmission direction, such acknowledgements may be transmitted from the cellular network to the communication device. The second control loop may be based on or may correspond to an OLLA process.

The offset may be monitored for a plurality of radio connections, in particular for a plurality of radio connections with transmission activity exceeding a threshold value. In the latter case, the transmission activities of the radio connections may be determined on the basis of a number of positive or negative acknowledgements of a HARQ protocol transmitted in the course of each radio connection. The plurality of radio connections may be established to a plurality of communication devices.

In some implementations, the offset may be monitored on the basis of reports provided by the at least one access node. In other implementations, the node may correspond to the access node and may monitor the offset as it is applied by the access node.

At step 920, the node determines the initial value of the offset to be applied by the at least one access node with respect to further radio connections to communication devices. Such further radio connections may be established to the same communication device(s) for which the offset was monitored at step 910, or to other communication devices. This is accomplished depending on the offset as monitored at step 920.

At step 930, the node may apply determined initial value of the offset. This may involve indicating the determined initial value of the offset to the access node and/or configuring an OLLA module of the access node accordingly.

In some implementations, the node may determine a histogram of values of the offset, each bin of the histogram indicating a number of observations of an adapted value of the offset in a value range corresponding to the bin. The initial value of the offset may then be determined on the basis of the histogram. For example, the initial value of the offset may be determined depending on the bin indicating the highest number, depending on a mean value of the histogram, depending on a median value of the histogram, depending on a mode value of the histogram, or depending on a percentile value of the histogram.

Accordingly, a node for a cellular network may be provided with a module configured to monitor an offset which is applied by at least one access node of the cellular network to adapt a signal quality value determined for a radio connection to a communication device, e.g., as explained in connection with step 910. This module may also be configured to generate or aggregate histograms of values of the applied offset, as explained above. Further, the node may be provided with a module configured to determine an initial value of the offset, e.g., as explained in connection with step 920. Further, the node may be provided with a module configured to apply the offset for further radio connections, e.g., as explained in connection with step 930.

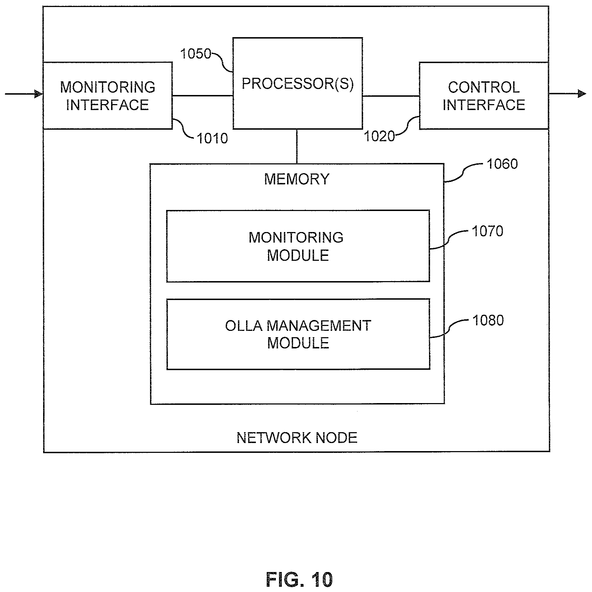

Fig. 10 illustrates exemplary structures which may be used for implementing the above concepts in a node of a cellular network, e.g., an access node such as a base station, e.g. the base station 100, or a management node, such as an OSS node, e.g. the OSS 200.

As illustrated, the node may include a monitoring interface 1010 for monitoring one or more access nodes of the cellular network. Further, the node may include a control interface 1020 for controlling one or more access nodes of the cellular network. If the node itself corresponds to an access node, the interfaces 1010, 1020 may correspond to internal interfaces of the node.

Further, the node may include one or more processors 1050 coupled to the interfaces 1010, 1020, and a memory 1060 coupled to the processor(s) 1050. The memory 1060 may include a Read Only Memory (ROM), e.g., a flash ROM, a Random Access Memory (RAM), e.g., a Dynamic RAM (DRAM) or Static RAM (SRAM), a mass storage, e.g., a hard disk or solid state disk, or the like. The memory 1060 includes suitably configured program code to be executed by the processor(s) 1050 so as to implement the above-described functionalities of the node. In particular, the memory 1060 may include various program code modules for causing the node to perform processes as described above, e.g., corresponding to the method steps of Fig. 9.

As illustrated, the memory 1060 may include a monitoring module 1070 for implementing the above-described functionalities of monitoring the offset which is applied by at least one access node of the cellular network to adapt a signal quality value determined for a radio connection to a communication device, e.g., as explained in connection with step 910 of Fig. 9. These functionalities may also include generating or aggregating histograms of values of the applied offset. Further, the memory 1060 may include an OLLA management module 1080 for implementing the above-described functionalities of determining the initial value of the offset, e.g., as explained in connection with step 920 of Fig. 9. Such determined initial value of the offset may then be applied when performing link adaptation of radio connections, e.g., by indicating the determined value through the control interface 1020.

It is to be understood that the structures as illustrated in Fig. 10 are merely schematic and that the node may actually include further components which, for the sake of clarity, have not been illustrated, e.g., further interfaces or processors. Also, it is to be understood that the memory 1060 may include further types of program code modules, which have not been illustrated, e.g., program code modules for implementing known functionalities of an access node or a management node. According to some embodiments, also a computer program may be provided for implementing functionalities of the node, e.g., in the form of a physical medium storing the program code and/or other data to be stored in the memory 1060 or by making the program code available for download or by streaming.

As can be seen, the concepts as described above may be used for optimizing the initial value of the offset applied in an OLLA process for link adaptation. In this way, convergence of the OLLA process may be expedited. This may in turn allow for increasing data throughput and transmission reliability. The concepts may be implemented with low complexity in a link adaptation mechanism based on ILLA and OLLA processes, requiring only little interaction and adjustments from the operator side. In some implementations, only configuration of the threshold $A_{Th}$ for identifying high activity radio connections needs to be accomplished by the operator. Further, the concepts may be implemented without excessive requirements concerning computational load. Although the proposed solution is based on the statistical analysis of monitored parameters may be utilized, this analysis may be performed offline without excessively consuming computational resources required for online operation of the cellular network. Further, since the optimization of the initial value of the offset may be based on monitoring a large number of radio connections, statistical analysis of the monitored offset may ensure high significance of the optimization results and the link adaptation process.

It is to be understood that the examples and embodiments as explained above are merely illustrative and susceptible to various modifications. For example, the illustrated concepts may be applied in connection with various radio technologies, without limitation to the above-mentioned examples LTE or UMTS radio technology. Further, the illustrated concepts may be applied in a localized manner at each access node responsible for performing link adaptation or in a centralized manner in a node which is responsible for management of multiple access nodes, e.g., an OSS node. Further, the concepts may be applied to the DL transmission direction and to the UL transmission direction. Moreover, it is to be understood that the above concepts may be implemented by using correspondingly designed software to be executed by one or more processors of an existing device, or by using dedicated device hardware. Further, it should be noted that the illustrated nodes may each be implemented as a single device or as a system of multiple interacting devices.

**Claims**

1.   A method of controlling radio connections in a cellular network, the method comprising:

> monitoring (910) an offset applied by at least one access node (100) of the cellular network to adapt a signal quality value determined for a radio connection to a communication device (10), the adapted signal quality value being applied in a first control loop to select a modulation and coding scheme for the radio connection, and the offset being adapted in a second control loop, starting from an initial value and depending on feedback information for transmissions on the radio connection; and
>
> depending on the monitored offset, determining (350, 920) the initial value of the offset to be applied by the at least one access node (100) with respect to further radio connections to communication devices (10),
> wherein the determining utilizes the monitored offset of only a plurality of radio connections with transmission activity exceeding a threshold value.

2.   The method according to claim 1,
  wherein the transmission activities of the radio connections are determined on the basis of a number of positive or negative acknowledgements of a Hybrid Automatic Repeat Request protocol transmitted in the course of each radio connection.

3.   The method according to claim 2, comprising:
  by comparing the number of positive and negative acknowledgements of the Hybrid Automatic Repeat Request protocol to the threshold value, classifying the monitored radio connections into low activity radio connections and high activity radio connections.

**4.** The method according to claim 3, further comprising:
utilizing only the values of the offset as monitored for high activity radio connections as a basis for determining the initial value of the offset.

**5.** The method according to any one of the preceding claims, comprising:

determining (310) a histogram of values of the offset, each bin of the histogram indicating a number of observations of an adapted value of the offset in a value range corresponding to the bin; and
determining (350, 920) the initial value of the offset on the basis of the histogram.

**6.** The method according to claim 5, comprising:
determining (350, 920) the initial value of the offset depending on the bin indicating the highest number.

**7.** The method according to claim 5 or 6, comprising:
determining (350, 920) the initial value of the offset depending on a mean value of the histogram.

**8.** The method according to any one of claims 5 to 7, comprising:
determining (350, 920) the initial value of the offset depending on a median value of the histogram.

**9.** The method according to any one of claims 5 to 8, comprising:
determining (350, 920) the initial value of the offset depending on a percentile value of the histogram.

**10.** The method according to any one of the preceding claims,
wherein the signal quality value is determined as a Signal to Interference plus Noise Ratio.

**11.** The method according to any one of the preceding claims,
wherein the feedback information comprises positive or negative acknowledgements of a Hybrid Automatic Repeat Request protocol.

**12.** The method according to any one of the preceding claims, comprising:

monitoring (910) the offset on the basis of reports provided by the at least one access node (100); and
indicating the determined value to the at least one access node (100).

**13.** A node (100, 200) for a cellular network, the node (100, 200) being configured to:

- monitor an offset applied by at least one access node (100) of the cellular network to adapt a signal quality value determined for a radio connection to a communication device (10), the adapted signal quality value being applied in a first control loop to select a modulation and coding scheme for the radio connection, and the offset being adapted in a second control loop, starting from an initial value and depending on feedback information for transmissions on the radio connection; and
- depending on the monitored offset, determine the initial value of the offset to be applied by the at least one access node (100) with respect to further radio connections to communication devices,

wherein the node (100, 200) is configured to determine the initial value by utilizing the monitored offset of only a plurality of radio connections with transmission activity exceeding a threshold value.

**14.** The node (100, 200) according to claim 13,
wherein the node (100, 200) is configured to perform the steps of a method according to any one of claims 1 to 12.

**15.** A computer program or computer program product comprising program code to be executed by at least one processor of a node (100, 200) of a cellular network, wherein execution of the program code causes the node (100, 200) to perform steps of a method according to any one of claims 1 to 12.

**Patentansprüche**

**1.** Verfahren zum Steuern von Funkverbindungen in einem zellularen Netz, wobei das Verfahren umfasst:

Überwachen (910) eines Offsets, der von mindestens einem Zugangsknoten (100) des zellularen Netzes angewendet wird, um einen für eine Funkverbindung zu einer Kommunikationsvorrichtung (10) bestimmten Signalgütewert anzupassen, wobei der angepasste Signalgütewert in einer ersten Regelschleife angewendet wird, um ein Modulations- und Codierungsschema für die Funkverbindung auszuwählen, und der Offset in einer zweiten Regelschleife angepasst wird, ausgehend von einem Anfangswert und in Abhängigkeit von Feedback-Informationen für Übertragungen auf der Funkverbindung; und

in Abhängigkeit von dem überwachten Offset, Bestimmen (350, 920) des Anfangswerts des Offsets, der von dem mindestens einen Zugangsknoten (100) in Bezug auf weitere Funkverbindungen zu Kommunikationsvorrichtungen (10) anzuwenden ist,

wobei das Bestimmen den überwachten Offset von nur einer Vielzahl von Funkverbindungen mit Übertragungsaktivität verwendet, die einen Schwellenwert überschreitet.

2. Verfahren nach Anspruch 1,
wobei die Übertragungsaktivitäten der Funkverbindungen auf der Basis einer Anzahl positiver oder negativer Bestätigungen eines Hybrid-Automatic-Repeat-Request-Protokolls bestimmt werden, das im Verlauf jeder Funkverbindung übertragen wird.

3. Verfahren nach Anspruch 2, umfassend:
durch Vergleichen der Anzahl positiver und negativer Bestätigungen des Hybrid-Automatic-Repeat-Request-Protokolls mit dem Schwellenwert, Klassifizieren der überwachten Funkverbindungen in Funkverbindungen mit geringer Aktivität und Funkverbindungen mit hoher Aktivität.

4. Verfahren nach Anspruch 3, ferner umfassend:
Verwenden nur der Werte des Offsets, wie sie für Funkverbindungen mit hoher Aktivität überwacht werden, als eine Basis zum Bestimmen des Anfangswerts des Offsets.

5. Verfahren nach einem der vorstehenden Ansprüche, umfassend:
Bestimmen (310) eines Histogramms von Werten des Offsets, wobei jede Klasse des Histogramms eine Anzahl von Beobachtungen eines angepassten Werts des Offsets in einem Wertebereich angibt, der der Klasse entspricht; und Bestimmen (350, 920) des Anfangswerts des Offsets auf der Basis des Histogramms.

6. Verfahren nach Anspruch 5, umfassend:
Bestimmen (350, 920) des Anfangswerts des Offsets in Abhängigkeit von der Klasse, die die höchste Anzahl angibt.

7. Verfahren nach Anspruch 5 oder 6, umfassend:
Bestimmen (350, 920) des Anfangswerts des Offsets in Abhängigkeit von einem Mittelwert des Histogramms.

8. Verfahren nach einem der Ansprüche 5 bis 7, umfassend:
Bestimmen (350, 920) des Anfangswerts des Offsets in Abhängigkeit von einem Medianwert des Histogramms.

9. Verfahren nach einem der Ansprüche 5 bis 8, umfassend:
Bestimmen (350, 920) des Anfangswerts des Offsets in Abhängigkeit von einem Perzentilwert des Histogramms.

10. Verfahren nach einem der vorstehenden Ansprüche,
wobei der Signalgütewert als ein Signal-to-Interference-plus-Noise-Ratio (SINR) bestimmt wird.

11. Verfahren nach einem der vorstehenden Ansprüche,
wobei die Feedback-Informationen positive oder negative Bestätigungen eines Hybrid-Automatic-Repeat-Request-Protokolls umfassen.

12. Verfahren nach einem der vorstehenden Ansprüche, umfassend:
Überwachen (910) des Offsets auf der Basis von Berichten, die von dem mindestens einen Zugangsknoten (100) bereitgestellt werden; und
Angeben des bestimmten Werts an den mindestens einen Zugangsknoten (100).

13. Knoten (100, 200) für ein zellulares Netz, wobei der Knoten (100, 200) konfiguriert ist zum:

- Überwachen eines Offsets, der von mindestens einem Zugangsknoten (100) des zellularen Netzes angewendet wird, um einen für eine Funkverbindung zu einer Kommunikationsvorrichtung (10) bestimmten Signalgütewert anzupassen, wobei der angepasste Signalgütewert in einer ersten Regelschleife angewendet wird, um ein Modulations- und Codierungsschema für die Funkverbindung auszuwählen, und der Offset in einer zweiten Regelschleife angepasst wird, ausgehend von einem Anfangswert und in Abhängigkeit von Feedback-Informationen für Übertragungen auf der Funkverbindung; und

- in Abhängigkeit von dem überwachten Offset, Bestimmen des Anfangswerts des Offsets, der von dem mindestens einen Zugangsknoten (100) in Bezug auf weitere Funkverbindungen zu Kommunikationsvorrichtungen anzuwenden ist,

wobei der Knoten (100, 200) konfiguriert ist zum Bestimmen des Anfangswerts durch Verwenden des überwachten Offsets von nur einer Vielzahl von Funkverbindungen mit Übertragungsaktivität, die einen Schwellenwert überschreitet.

**14.** Knoten (100, 200) nach Anspruch 13,
wobei der Knoten (100, 200) dazu konfiguriert ist, die Schritte eines Verfahrens nach einem der Ansprüche 1 bis 12 durchzuführen.

**15.** Computerprogramm oder Computerprogrammprodukt, das einen Programmcode umfasst, der durch mindestens einen Prozessor eines Knotens (100, 200) eines zellularen Netzes auszuführen ist, wobei die Ausführung des Programmcodes bewirkt, dass der Knoten (100, 200) Schritte eines Verfahrens nach einem der Ansprüche 1 bis 12 durchführt.

## Revendications

**1.** Procédé de commande de connexions radio dans un réseau cellulaire, le procédé comprenant :

la surveillance (910) d'un décalage appliqué par au moins un nœud d'accès (100) du réseau cellulaire pour adapter une valeur de qualité de signal déterminée pour une connexion radio vers un dispositif de communication (10), la valeur de qualité de signal adaptée étant appliquée dans une première boucle de commande pour sélectionner un schéma de modulation et de codage pour la connexion radio, et le décalage étant adapté dans une deuxième boucle de commande, en partant d'une valeur initiale et en fonction d'informations de rétroaction pour des transmissions sur la connexion radio ; et

en fonction du décalage surveillé, la détermination (350, 920) de la valeur initiale du décalage à appliquer par l'au moins un nœud d'accès (100) par rapport à d'autres connexions radio vers des dispositifs de communication (10),

dans lequel la détermination utilise le décalage surveillé uniquement d'une pluralité de connexions radio avec une activité de transmission dépassant une valeur seuil.

**2.** Procédé selon la revendication 1,
dans lequel les activités de transmission des connexions radio sont déterminées sur la base d'un nombre d'accusés de réception positifs ou négatifs d'un protocole de demande de répétition automatique hybride transmis au cours de chaque connexion radio.

**3.** Procédé selon la revendication 2, comprenant :
en comparant le nombre d'accusés de réception positifs et négatifs du protocole de demande de répétition automatique hybride à la valeur seuil, la classification des connexions radio surveillées en connexions radio à faible activité et connexions radio à haute activité.

**4.** Procédé selon la revendication 3, comprenant en outre :
l'utilisation uniquement des valeurs du décalage telles que surveillées pour des connexions radio à haute activité en tant que base pour déterminer la valeur initiale du décalage.

**5.** Procédé selon l'une quelconque des revendications précédentes, comprenant :
la détermination (310) d'un histogramme de valeurs du décalage, chaque intervalle de l'histogramme indiquant un nombre d'observations d'une valeur adaptée du décalage dans une plage de valeurs correspondant à l'intervalle ; et la détermination (350, 920) de la valeur initiale du décalage sur la base de l'histogramme.

**6.** Procédé selon la revendication 5, comprenant :
la détermination (350, 920) de la valeur initiale du décalage en fonction de l'intervalle indiquant le nombre le plus élevé.

**7.** Procédé selon la revendication 5 ou 6, comprenant :
la détermination (350, 920) de la valeur initiale du décalage en fonction d'une valeur moyenne de l'histogramme.

**8.** Procédé selon l'une quelconque des revendications 5 à 7, comprenant :
la détermination (350, 920) de la valeur initiale du décalage en fonction d'une valeur médiane de l'histogramme.

**9.** Procédé selon l'une quelconque des revendications 5 à 8, comprenant :
la détermination (350, 920) de la valeur initiale du décalage en fonction d'une valeur de centile de l'histogramme.

**10.** Procédé selon l'une quelconque des revendications précédentes,
dans lequel la valeur de qualité de signal est déterminée en tant que rapport signal-bruit plus interférence.

**11.** Procédé selon l'une quelconque des revendications précédentes,
dans lequel les informations de rétroaction comprennent des accusés de réception positifs ou négatifs d'un protocole de demande de répétition automatique hybride.

**12.** Procédé selon l'une quelconque des revendications précédentes, comprenant :

la surveillance (910) du décalage sur la base de rapports fournis par l'au moins un nœud d'accès (100) ; et
l'indication de la valeur déterminée à l'au moins un nœud d'accès (100).

**13.** Nœud (100, 200) pour un réseau cellulaire, le nœud (100, 200) étant configuré pour :

- surveiller un décalage appliqué par au moins un nœud d'accès (100) du réseau cellulaire pour adapter une valeur de qualité de signal déterminée pour une connexion radio vers un dispositif de communication (10), la valeur de qualité de signal adaptée étant appliquée dans une première boucle de commande pour sélectionner un schéma de modulation et de codage pour la connexion radio, et le décalage étant adapté dans une deuxième boucle de commande, en partant d'une valeur initiale et en fonction d'informations de rétroaction pour des transmissions sur la connexion radio ; et
- en fonction du décalage surveillé, déterminer la valeur initiale du décalage à appliquer par l'au moins un nœud d'accès (100) par rapport à d'autres connexions radio vers des dispositifs de communication,

dans lequel le nœud (100, 200) est configuré pour déterminer la valeur initiale en utilisant le décalage surveillé uniquement d'une pluralité de connexions radio avec une activité de transmission dépassant une valeur seuil.

**14.** Nœud (100, 200) selon la revendication 13,
dans lequel le nœud (100, 200) est configuré pour mettre en œuvre les étapes d'un procédé selon l'une quelconque des revendications 1 à 12.

**15.** Programme informatique ou produit programme informatique comprenant un code de programme à exécuter par au moins un processeur d'un nœud (100, 200) d'un réseau cellulaire, dans lequel une exécution du code de programme amène le nœud (100, 200) à mettre en œuvre des étapes d'un procédé selon l'une quelconque des revendications 1 à 12.

FIG. 1

FIG. 2

310 — COLLECT HISTOGRAMS — STAGE 1

320 — SELECT HISTOGRAMS OF HIGH ACTIVITY CONNECTIONS — STAGE 2

330 — AGGREGATE SELECTED HISTOGRAMS — STAGE 3

$T_{OP}$ ? — N

Y — 340

350 — CALCULATE OPTIMZED VALUE OF $\Delta_{INI}$ — STAGE 4

360 — PROVIDE OPTIMZED VALUE OF $\Delta_{INI}$ TO OLLA MODULE OF BS — STAGE 5

**FIG. 3**

| $\Delta_{OLLA}$ COUNTER | $\Delta_{OLLA}$ INTERVAL (BIN) |
|---|---|
| $\Delta_{OLLA}[1]$ | $\Delta_{OLLA} \leq L_1$ |
| $\Delta_{OLLA}[2]$ | $L_1 < \Delta_{OLLA} \leq L_2$ |
| $\Delta_{OLLA}[3]$ | $L_2 < \Delta_{OLLA} \leq L_3$ |
| ... | ... |
| $\Delta_{OLLA}[N-1]$ | $L_{N-2} < \Delta_{OLLA} \leq L_{N-1}$ |
| $\Delta_{OLLA}[N]$ | $L_{N-1} < \Delta_{OLLA}$ |

**FIG. 4**

| $\Delta_{OLLA}$ COUNTER | $\Delta_{OLLA}$ INTERVAL (BIN) |
|---|---|
| $\Delta_{OLLA}[1]$ | $7 \text{ dB} < \Delta_{OLLA}$ |
| $\Delta_{OLLA}[2]$ | $3 \text{ dB} < \Delta_{OLLA} \leq 7 \text{ dB}$ |
| $\Delta_{OLLA}[3]$ | $1 \text{ dB} < \Delta_{OLLA} \leq 3 \text{ dB}$ |
| $\Delta_{OLLA}[4]$ | $-1 \text{ dB} < \Delta_{OLLA} \leq 1 \text{ dB}$ |
| $\Delta_{OLLA}[5]$ | $-3 \text{ dB} < \Delta_{OLLA} \leq -1 \text{ dB}$ |
| $\Delta_{OLLA}[6]$ | $-7 \text{ dB} < \Delta_{OLLA} \leq -3 \text{ dB}$ |
| $\Delta_{OLLA}[7]$ | $-10 \text{ dB} < \Delta_{OLLA} \leq -7 \text{ dB}$ |
| $\Delta_{OLLA}[8]$ | $\Delta_{OLLA} \leq -10 \text{ dB}$ |

FIG. 5

EP 3 259 862 B1

**FIG. 6**

**FIG. 7**

**FIG. 8**

910 — MONITOR OFFSET

920 — DETERMINE INITIAL VALUE OF OFFSET

930 — APPLY INITIAL VALUE OF OFFSET

**FIG. 9**

**FIG. 10**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20150049703 A1

- WO 2010041990 A1

### Non-patent literature cited in the description

- *3GPP TS 36.300 V12.4.0,* December 2014
- **AHO, K. ; ALANEN O. ; KAIKKONEN J.** CQI Reporting Imperfections and their Consequences in LTE Networks. *10th International Conference on Networks (ICN),* January 2011, ISSN 2308-4413, ISBN 978-1-61208-113-7, 241-245

- **MULLER, A. ; CHEN, T.** Improving HSDPA link adaptation by considering the age of CQI. *62nd IEEE Vehicular Technology Conference (VTC),* September 2005, vol. 3, ISSN 1090-3038, 1643-1647